# EUROPEAN PATENT APPLICATION

(11) **EP 1 845 567 A1**
(43) Date of publication of application: **17.10.2007**
(21) Application number: 06425257.0
(22) Date of filing: 11.04.2006
(51) Int. Cl.: H01L 45/00, H01L 27/24

(54) **Phase-change memory device and manufacturing process thereof.**

(71) Applicant: STMicroelectronics S.r.l., 20041 Agrate Brianza (Milano) (IT)
(72) Inventor: Pellizzer, Fabio, 31051 Follina (IT); Ottogalli, Federica, 30174 Mestre (IT)
(74) Representative: Cerbaro, Elena

(57) **Abstract**

Phase-change memory cell (61), formed by a phase-change memory element (64) and by a selection element (65), which is formed in a semiconductor material body (20) and is connected to the phase-change memory element (64). The phase-change memory element (64) is made up of a chalcogenic material layer (17) and a heater (63). The selection element (65) is in direct contact with the heater (63) and extends through a dielectric region (38,24) arranged on top of and contiguous to the semiconductor material body (20). A dielectric material layer (32) is arranged on the dielectric region (24) and houses a portion of the chalcogenic material layer (17).

## Description

The present invention relates to a semiconductor memory device, in particular a non-volatile phase-change memory device, and the manufacturing process thereof.

As is known, in phase-change memory devices a class of materials is used that present the property of being able to pass, in a reversible way, through different states, or phases, presenting different electrical characteristics. For example, these materials can pass from a disorderly amorphous state to an orderly crystalline or polycrystalline state, and very different values of electrical resistivity are associated to these two states.

Currently, alloys of elements of group VI of the periodic table, such as Te or Se, referred to as calcogenides or calcogenic materials, are used in phase-change memory devices. The currently most promising calcogenide is formed by an alloy of Ge, Sb and Te (Ge₂Sb₂Te₅) and is widely used for storing data on re-writable optical disks.

In calcogenides, the resistivity changes by two or more orders of magnitude when the material passes from the more resistive amorphous state to the more conductive crystalline state, and vice versa.

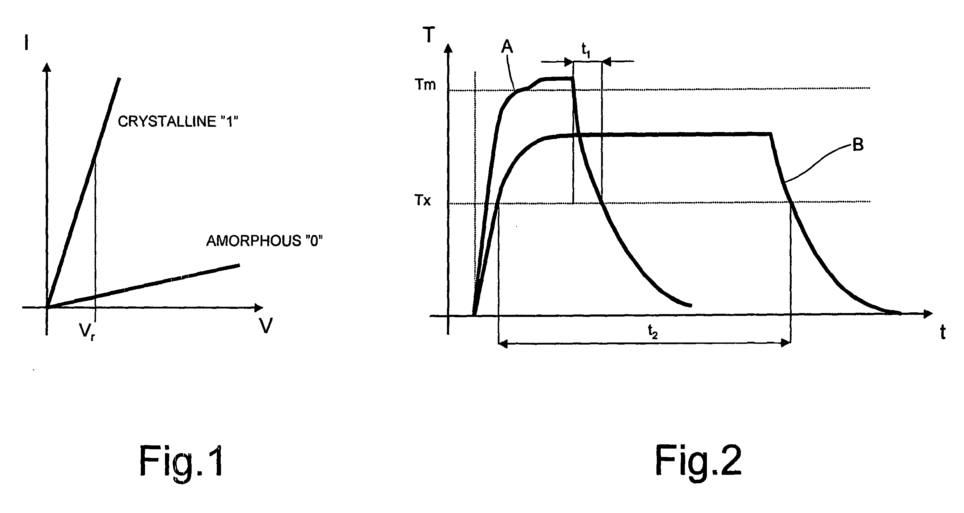

The characteristics of calcogenides in the two states are illustrated in Figure 1. At a preset read voltage, designated by Vr, the two states show a difference of more than ten times in the resistance.

The phase change can be obtained by locally increasing the temperature, as illustrated in Figure 2. Below 140°C both phases are stable. If the material is in the amorphous phase, above 190°C, a temperature designated by Tx, a fast nucleation of the crystals begins and, if the material is kept at the temperature of crystallization for a sufficiently long time (t₂), it undergoes phase change and becomes crystalline. To bring the calcogenide back to the amorphous state, it is necessary to raise the temperature above the melting point (Tm, approximately about 600°C), and then bring it down fast (t₁).

From an electrical standpoint, it is possible to reach both critical temperatures (crystallization and melting) by passing a current through a resistive element, which heats the calcogenic material by the Joule effect.

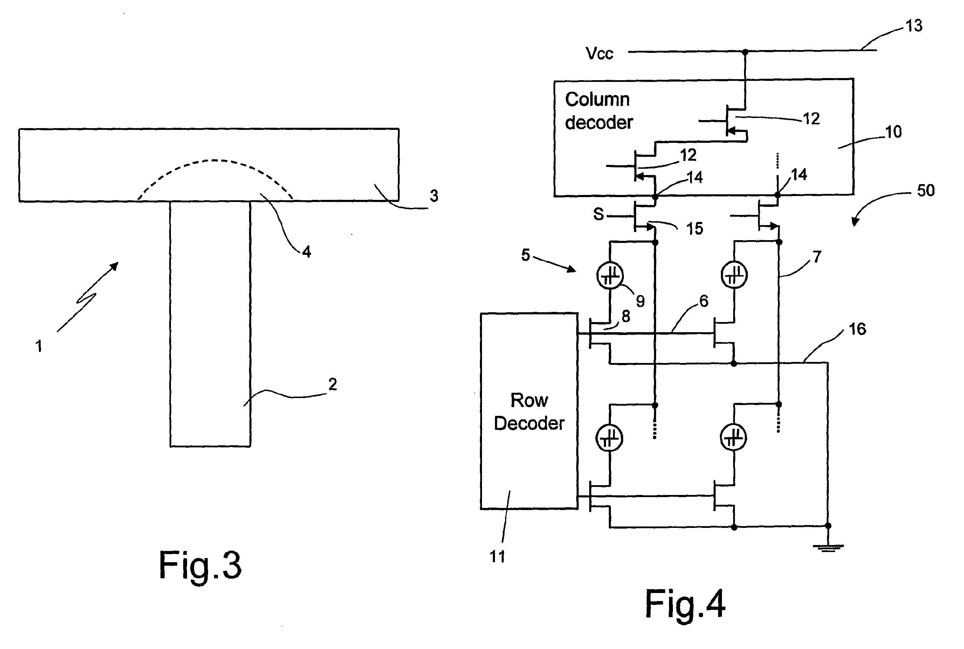

The basic structure of a memory element 1 of the phase-change type that behaves according to the above is illustrated in Figure 3 and comprises a resistive element 2, referred to as heater, and a programmable element 3. The programmable element 3 is formed by a calcogenide and is normally in the crystalline state so as to guarantee a good flow of current. A part of the programmable element 3 is in direct contact with the heater 2 and forms a phase-change portion 4.

If an electric current of appropriate value is passed through the heater 2, it is possible to heat the phase-change portion 4 up to the temperature of crystallization or of melting and to bring about a phase change.

Since the current that traverses the calcogenic material is proportional to its conductivity, the state of the calcogenide can be recognized by applying a voltage that is sufficiently low as not to cause a sensible increase in heat and by reading the current that is flowing.

In practice, a phase-change memory element can be considered as a resistor that conducts an amount of current that is different according to its phase. In particular, the following convention is used: a phase-change memory element is said to be in the "on" state (set) if, by applying an appropriate voltage, it conducts a detectable current, a condition that can be associated to the logic state "1"; instead, it is said to be in the "off" state (reset) if, in the same voltage conditions, it does not conduct current or else conducts a current that is very small as compared to that of an active phase-change memory element, a condition that is associated to the logic state "0".

Of course, the calcogenide can be made to pass electrically through different intermediate states between the amorphous one and the crystalline one, thus enabling a multilevel memory to be obtained.

As illustrated in Figure 4, the use of phase-change memory elements is known in memory arrays 50 formed by a plurality of memory cells 5 arranged in rows and columns, and electrically connected to wordlines 6 that are parallel to the rows of the memory array, and bitlines 7 that are parallel to the columns.

In the memory array 50, it is possible to program or read a single memory cell 5 by supplying an appropriate voltage to the respective bitline 7 and wordline 6 and connecting to ground all the other bitlines and wordlines.

Figure 4 also shows a possible circuit for driving a memory cell 5 by a column decoder 10 and a row decoder 11, as described in patent application No. EP 1 216 244, filed in the name of the present applicant. In particular, two decoding transistors 12 of the column decoder 10 are illustrated, which are connected between a supply line 13 and a selection node 14. Other pairs of decoding transistors 12 (not illustrated) are connected between the supply line 13 and other selection nodes 14 for all the other columns. The decoding transistors 12 are PMOS transistors connected in series and are driven by electrical signals that supply an appropriate voltage for turning on/off the transistors.

Each selection node 14 is connected to the drain terminal of a respective selection transistor 15, of an NMOS type, which forms a column selector and has a source terminal connected to a bitline 7, and is used for selecting the operation (read, write/erase) to be carried out on the memory cell 5; to this end, the column selector 15 receives an appropriate selection signal S.

Each memory cell 5 comprises a phase-change memory element 9, similar to the memory element 1 of Figure 3, and a selection element 8, for example a MOS transistor, a diode, or a bipolar transistor, which reduces the disturbance due to the presence of nearby memory cells 5 and is connected in series to the phase-change memory element 9.

In each memory cell 5, the selection element 8, in the example illustrated an NMOS transistor, has its gate terminal connected to a wordline 6, which extends from the row selector 11, its source terminal connected to ground through a source line 16, and its drain terminal connected to a first terminal of the phase-change memory element 9. A second terminal of the phase-change memory element 9 is connected to a bitline 7.

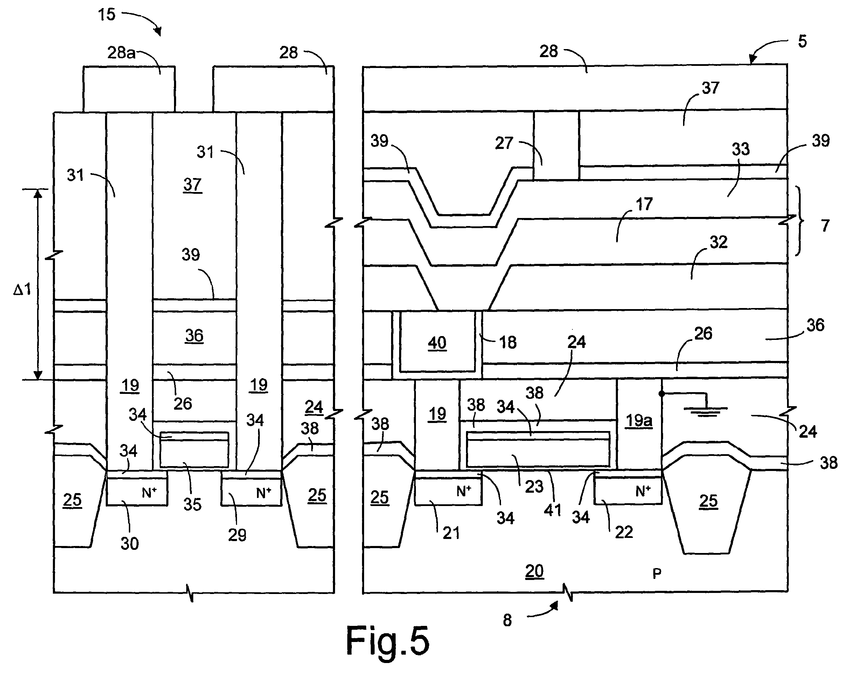

Figure 5 illustrates in detail, in a direction parallel to the bitlines 7, a cross-section (not represented in scale and represented only as regards the layers of interest, of a memory cell 5 of the memory array 50, as well as of a column selector 15.

As illustrated, the memory cell 5 comprises a layer 17 of calcogenic material, which corresponds to the programmable element 3 of Figure 3 and, together with an overlying metal layer 33, forms a bitline 7.

As described, for example, in the patent application No. EP 1 318 552, filed in the name of the present applicant, a heater 18, corresponding to the resistive element 2 of Figure 3 and in direct contact, at its top, with the calcogenide 17, extends vertically for a height equal to approximately 200-250 nm, and is in contact, at its bottom, with a first-level metal plug 19. The plug 19 in turn extends vertically as far as a substrate 20 of P type, specifically as far as a silicided surface area 34 of a drain region 21, of N+ type, of the selection element 8.

A gate region 23, insulated from the substrate 20 by a dielectric 41, is in contact with a wordline 6 (not illustrated in the figure), and overlies a channel region formed by the portion of substrate 20 between the drain region 21 and a source region 22 of N+ type, which is also formed within the substrate 20 and grounded through a source line 19a, formed by a trench obtained in the same way as the first-level plug 19 and extending perpendicular to the cross-section of Figure 5; the source line 19a is then contacted by second-level plugs (not illustrated).

Also the source region 22 and gate region 23 of the selection element 8 typically have a silicided surface area 34, which ensures an interface of good quality with the first-level plugs 19 and forms a low-resistance area that favours the passage of the current through the selection element 8.

The portion of substrate 20 forming part of the memory cell 5 is insulated from the neighbourhood through insulation regions 25 of dielectric material, formed, for example, using the STI (Shallow Trench Isolation) technique.

A top metal connection line 28, connected to the bitline 7 through a first metal conductive region or via 27, connects together the memory cell 5 and the column selector 15; the column selector 15 comprises a source 29, a drain 30, of N+ type, and a gate 35, which in turn comprise a silicided surface area 34.

The source 29 and drain 30 of the column selector 15 are connected to the connection line 28 and to a further metal line 28a through first-level plugs 19 and second metal conductive regions 31. Conductive regions (not illustrated), similar to the conductive regions 31, contact the source line 19a.

The active elements of the memory cell 5 and of the column selector 15, which are located on top of the substrate 20, are insulated from the neighbourhood by dielectric layers of different materials, for example USG (Undoped Silicon Glass) layers 24, 36, 37, 40 and silicon-nitride (Si₃N₄) layers 38, 26, 32, 39.

Albeit advantageous from various points of view, the structure just described has, however, certain drawbacks, in particular as regards some steps of the process necessary for its fabrication.

For example, the step of opening the second vias 31 on the first-level plugs 19 is somewhat complicated and difficult, given the need to etch dielectric layers of different material present on top of one another, and calls for a long and complicated sequence of a large number of etches alternately selective with respect to silicon nitride and with respect to silicon oxide.

In addition, the difference in height Δ1 between the first conductive region 27, which ends in contact with the bitline 7, and the second conductive region 31, which reaches as far as the first-level plugs 19, is very great, since it is equal to the sum of the height of the bitline 7, of the layer of silicon-nitride 32, of the heater 18, and of the silicon-nitride layer 26, for a total of approximately 400 nm.

This big difference in height makes it extremely problematical to form the first conductive region 27 and the second conductive region 31 simultaneously, since when the etch necessary for opening the first conductive region 27 reaches the top of the bitline 7, it is still very far from the first-level plugs 19, which must be reached to enable opening of the second conductive region 31.

Furthermore, also the subsequent step of filling of the second conductive regions 31 with metal material, generally tungsten (W), can prove complicated and difficult to carry out on account of their great height, which is finally approximately 600 nm.

In addition, given that the heater 18 and the drain region 21 are connected by a first-level plug 19, typically comprising tungsten (W), between them there is present an interface that is far from efficient and comprises materials with very different characteristics, for example TiSiN and W.

The aim of the present invention is consequently to provide a phase-change memory device and the manufacturing process thereof that will overcome the drawbacks described.

According to the present invention, a phase-change memory cell and the manufacturing process thereof are provided, as defined in claims 1 and 9, respectively.

For an understanding of the present invention, a first embodiment thereof is now described, purely by way of non-limiting example, with reference to the attached drawings, wherein:
- Figure 1 illustrates the known current-voltage characteristic of a phase-change material;
- Figure 2 is a schematic representation of the known behaviour of a phase-change material vs. temperature;
- Figure 3 shows the basic structure of a known phase-change memory element;
- Figure 4 illustrates a known driving scheme of a phase-change memory cell, within a memory array of a phase-change memory device;
- Figure 5 is a cross-section of the structure of a phase-change memory cell and of a column selector of a memory array, according to the prior art;
- Figure 6 is a cross-section of the structure of a phase-change memory cell and of a column selector of a memory array, according to a first embodiment of the invention;
- Figures 7a-7f are cross-sections of the phase-change memory device of Figure 6, in successive manufacturing steps; and
- Figures 8 and 9 are two mutually perpendicular cross-sections of the structure of a phase-change memory cell and of a column selector of a memory array, according to a second embodiment of the invention.

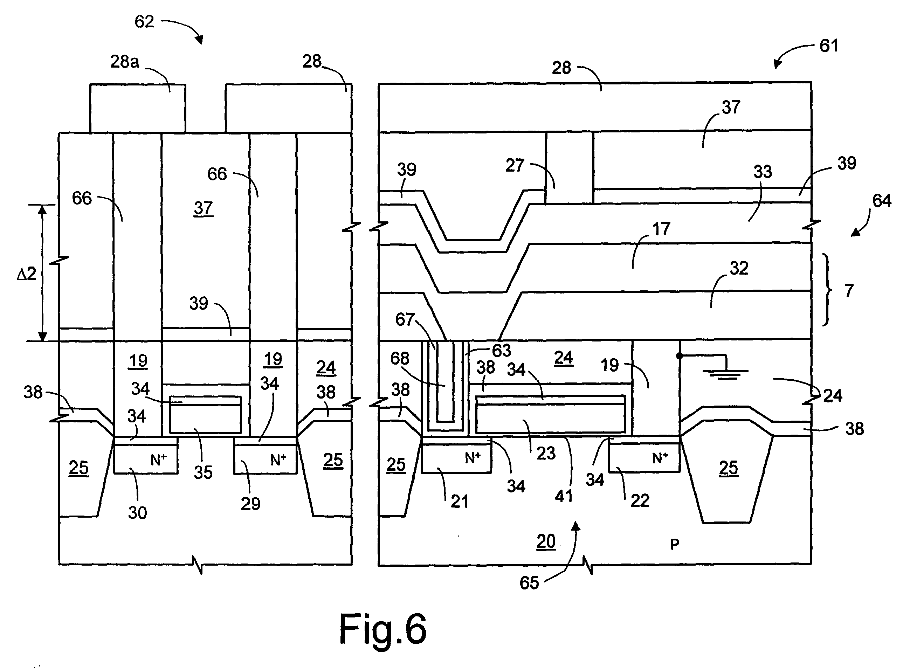

Figure 6 is a cross-section, not in scale and limited only to the layers of interest, of a first embodiment of a phase-change memory device. In particular, it shows a cross-section, in a direction parallel to the bitlines 7, of a memory cell 61 of the phase-change type, forming part of a memory array, and of a column selector 62, of NMOS type, of the memory array.

In the following description, the column selector 62 is used simply as non-limiting example of what happens, during the manufacturing process, to the logic and analog components external to the array.

The memory cell 61 comprises a memory element 64, corresponding to the memory element 1 of Figure 3, and a selection element 65, for example an NMOS transistor.

In detail, the memory cell 61 comprises a calcogenic material layer 17, for example GST (Ge₂Sb₂Te₅), of a height about 70 nm and corresponding to the programmable element 3 of Figure 3, in contact, at its top, with at least one metal layer 33, comprising, for example, titanium and titanium nitride (Ti/TiN), with a height of about 50 nm. The stack of the calcogenic material layer 17 and of the metal layer 33 forms a bitline 7, which extends along the memory cell 61.

A heater 63, corresponding to the resistive element 2 of Figure 2, is in direct contact, at its top, with the calcogenic material layer 17 and comprises a material that has a resistivity preferably comprised between 1 and 10 mΩ cm, which is stable as the temperature varies (at least up to a temperature of approximately 700-800°C, immediately above the melting point of the phase-change materials), is compatible with CMOS technology and produces an interface of good quality with the calcogenic materials. For example, the heater 63 can comprise TiSiN, TiAlN, or TiSiC, preferably TiSiN, having a thickness of preferably about 5 nm.

The heater 63 advantageously extends vertically for approximately 500 nm as far as a substrate 20 of type P, and is in direct contact, on the bottom, with a drain region 21, of N+ type, of the selection element 65, in particular with a surface area 34, preferably silicided, of the drain region 21.

A gate region 23, for example of polysilicon and in contact with a wordline 6 (not illustrated in the figure), is insulated from the substrate 20 through a dielectric 41, and overlies a channel region formed by the portion of substrate 20 between the drain region 21 and a source region 22; source region 22 is also of N+ type, formed within the substrate 20 and grounded through a source line 19a.

Also the source region 22 and gate region 23 of the selection element 65 preferably have a silicided surface area 34, which ensures an interface of good quality with the first-level plugs 19, 19a and forms a low-resistance area that favours the passage of the current through the selection element 65.

The portion of substrate 20 forming part of the memory cell 61 is insulated from the neighbourhood through insulation regions 25 of dielectric material, formed, for example, using the STI (Shallow Trench Isolation) technique.

A connection line 28, of metal material, comprising, for example, a multilayer of Ti/AlCu/TiN and connected to the bitline 7 through a first metal conductive region 27, for example comprising tungsten (W), connects the memory cell 61 and the column selector 62. Column selector 62 comprises a drain region 30 and a source region 29 of N+ type, and a gate region 35, for example of polysilicon, preferably comprising a silicided surface area 34.

The source region 29 and drain region 30 of the column selector 62 are connected to the connection line 28 and to a further metal line 28a through first-level plugs 19 and second metal conductive regions 66, for example, of tungsten (W).

The active elements of the memory cell 61 and of the column selector 62 that are located on top of the substrate 20 are insulated from the neighbourhood by dielectric layers of different materials, for example silicon oxide (SiO₂) 37, USG (Undoped Silicon Glass) 24 and silicon nitride (Si₃N₄) 38, 32, 39 and 67.

In the structure according to the invention, the difference in height Δ2 between the first conductive region 27, which terminates on the bitline 7, and the second conductive regions 66, which arrive as far as the first-level plugs 19, is represented advantageously only by the sum of the height of the bitline 7, which is approximately 120 nm, and of the silicon-nitride layer 32, which is approximately 60 nm, for a total of approximately 200 nm, and consequently the final structure is conveniently slender and compact.

Hereinafter, a first embodiment of a process for manufacturing the device of Figure 6 is described, provided purely by way of non-limiting example.

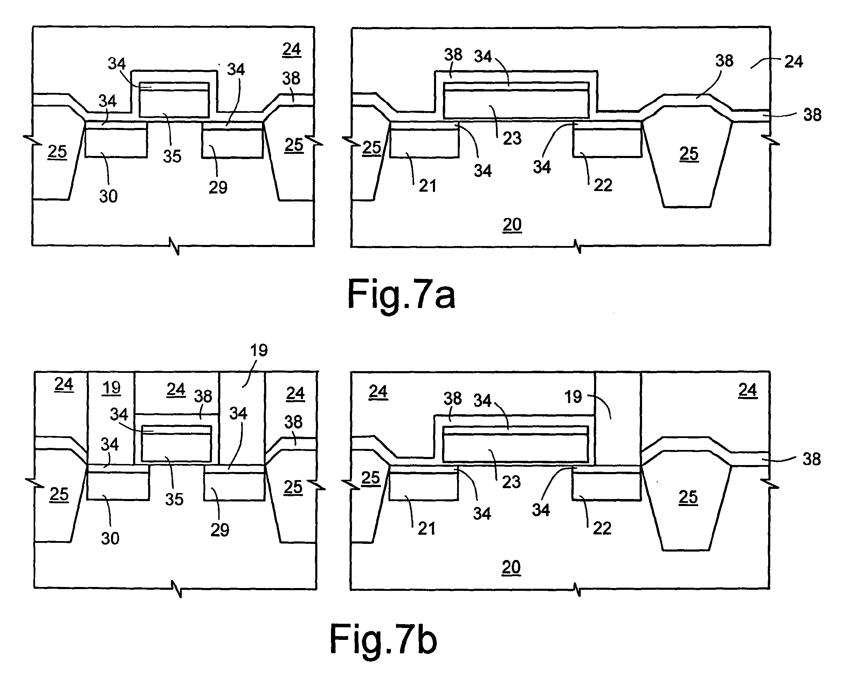

Initially (Figure 7a), the insulation regions 25 are formed within the substrate 20, in a per se known manner, for example using the STI technique; the drain regions 21, 30, and the source regions 22, 29 are also formed within the substrate 20; the gate regions 23, 35, and the corresponding silicided surface areas 34 are formed on top of the substrate 20.

Next, a borderless dielectric layer 38, e.g., silicon nitride with a thickness of about 20 nm, and a first dielectric layer 24, for example USG (Undoped Silicon Glass), with a thickness of about 600 nm are deposited.

Then (Figure 7b), holes are opened within the first dielectric layer 24 and the borderless dielectric layer 38 using, for example, a lithography and anisotropic etching step. The holes are subsequently filled with metal material, for example comprising tungsten, and finally the metal material in excess is removed, for example using the CMP (Chemical Mechanical Polishing) technique, thus forming the first-level plugs 19 and the source line 19a. In this way, a structure with substantially planar morphology is obtained, with a height of about 500 nm starting from the substrate 20.

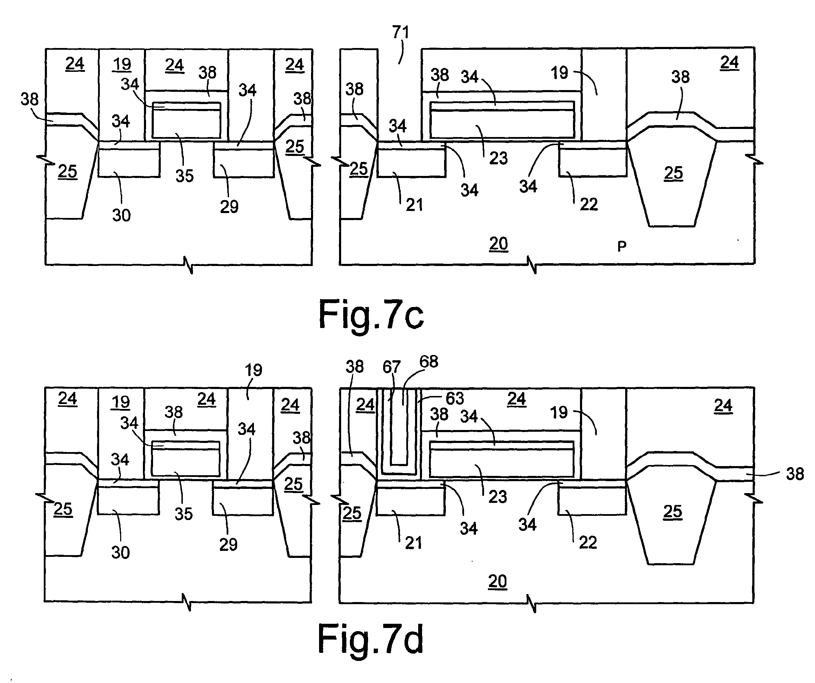

Next (Figure 7c), an opening 71 is formed in the dielectric layers 24 and 38, over the drain region 21 of the selection element 65, with a depth equal to that of the first-level plugs 19, i.e., comprised between 400 nm and 600 nm, for example approximately 500 nm, starting from the substrate 20.

Next (Figure 7d), the heater 63 is formed by depositing a thin layer, comprising, for example, TiSiN, with a thickness comprised between 1 nm and 30 nm, preferably 5 nm, which follows the profiles of the walls of the opening 71 in a conformal way. The portion within the opening 71 left free by the heater 63 is filled with a protective dielectric 67 (sheath layer 67, e.g., silicon nitride with a thickness of about 20 nm) and then with the same dielectric material as the first dielectric layer 24 used previously, for example USG (filling region 68); and the amount in excess of dielectric 68 and 67 and of the material of the heater 63 is removed, for example using the CMP technique, so as to obtain a structure with substantially planar morphology.

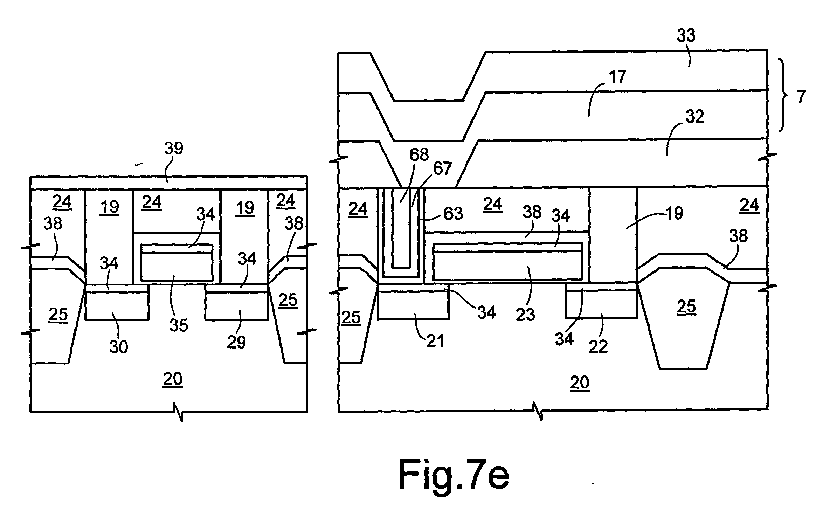

Then (Figure 7e), a second dielectric layer 32, preferably silicon nitride (Si₃N₄), with a thickness of about 60 nm is deposited and is then dug over the heater 63, using, for example, a chemical-physical plasma etch so as to obtain a preferably funnel-shaped trench. The bitline 7 is then formed by depositing the calcogenic material layer 17 and the metal layer 33.

In particular, the calcogenic material layer 17, for example GST (Ge₂Sb₂Te₅) with a thickness of about 70 nm, fills the funnel-shaped trench and has a portion of the bottom wall in direct contact with the underlying heater 63. The calcogenic material layer 17 is deposited, for example, using the PVD (Physical Vapour Deposition) technique, at an appropriate temperature so that it is in the crystalline state. The metal layer 33, for example comprising titanium and titanium nitride (Ti/TiN) has a thickness of about 50 nm.

The metal layer 33, the calcogenic material layer 17, and the second dielectric layer 32 are then removed from the areas where they are not necessary, through an etching step in sequence that completes the formation of the bitline 7.

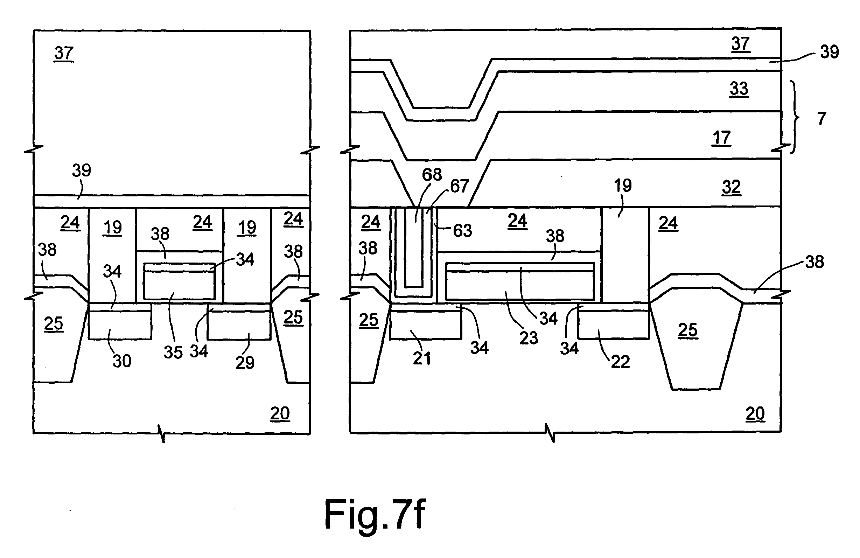

Next (Figure 7f), a third dielectric layer 39 is deposited, for example silicon nitride for a thickness of about 20 nm, for sealing the bitline 7, isolating it from possible contamination (oxygen, humidity, metal ions, etc.) from the neighbourhood. Finally, a fourth dielectric layer 37 is deposited, for example silicon oxide or USG with a thickness of about 500 nm. The fourth dielectric layer 37, deposited, for example using the HDP (High Density Plasma) technique, is then planarized, for example using the CMP technique, so as to obtain a structure with substantially planar morphology, with a thickness of about 200 nm from the top of the bitline 7.

Then, the first conductive region 27, which ends on the bitline 7, and the second conductive regions 66, which ends on the first-level plugs 19, are opened. The conductive regions 27, 66 are opened using a lithography step and, advantageously, a subsequent single anisotropic etching step, which comprises an etch in sequence of the fourth dielectric layer 37 and of the third dielectric layer 39. The first conductive region 27, which has a height of approximately 200 nm, and the second conductive regions 66, which have a height of approximately 400 nm, are subsequently filled with metal material, for example tungsten (W).

Finally, a metal layer, comprising, for example, a multilayer of Ti/AlCu/TiN, which forms the connection lines 28 and 28a, is deposited and defined in a per se known manner, to obtain the final structure of Figure 6.

The manufacturing process of the memory device proceeds from this point on according to standard-process steps, such as deposition of an intermediate dielectric layer, opening and filling of second-level conductive regions, deposition of further metal connection lines, and deposition of the passivation layers.

Advantageously, the heater 63 is in direct contact with the drain region 21, and the interface that is formed between the two elements is particularly effective, since it involves similar materials, for example TiSiN and TiSi₂.

In addition, the difference in height Δ2 between the first conductive region 27 that ends on the bitline 7 and the second conductive regions 66 that end on the first-level plugs 19, is advantageously less than the difference in height Δ1, present in the prior art between similar elements, by an amount equal to the height of the heater 18, which is indicatively approximately 200-250 nm.

The reduced difference in height between the first conductive region 27 and the second conductive regions 66 results in a final structure that is more slender and compact than the prior art, with consequent advantages in the electrical performance of the memory device as a whole.

Furthermore, with the process described, the etching operation that opens the first conductive region 27 and the second conductive regions 66 can be performed advantageously in a single step, through a continuous sequence of just two etches, which in the example described above are selective, the first with respect to silicon nitride and the second with respect to silicon oxide, i.e., a rather simple sequence to follow even within a single etching step.

According to the process described, the very dynamics of the step of opening of the first conductive region 27 and of the second conductive regions 66 just described is considerably simplified with respect to the prior art: in fact, the last layer to be etched for opening the second conductive regions 66 is advantageously a silicon nitride layer that is sufficiently thick to enable the use in the etching operation of a so-called "end-point" technique, in which the recognition of the material to be etched by the etching machine enables interruption of the etch in a very precise way at the appropriate moment.

Finally, it is clear that numerous modifications and variations can be made to the phase-change memory device and to the manufacturing process described and illustrated herein, without thereby departing from the scope of the present invention, as defined in the attached claims.

For example, the bitline 7 can comprise, on top of the metal layer 33, one or more additional layers of metal material, comprising, for example, an aluminium and copper alloy (AlCu).

The silicided surface area 34 is not essential for the purposes of the invention: in fact, the presence of a silicide enables an interface of excellent quality between the heater 63 and the drain region 21 to be obtained, but in principle it is possible to terminate the heater 63 directly on the silicon of the substrate 20 of the drain region 21, doing without silicide.

In addition, the selection element of the memory cell 61 does not necessarily have to be a MOSFET, but may be a transistor of another type, for example a diode or a BJT.

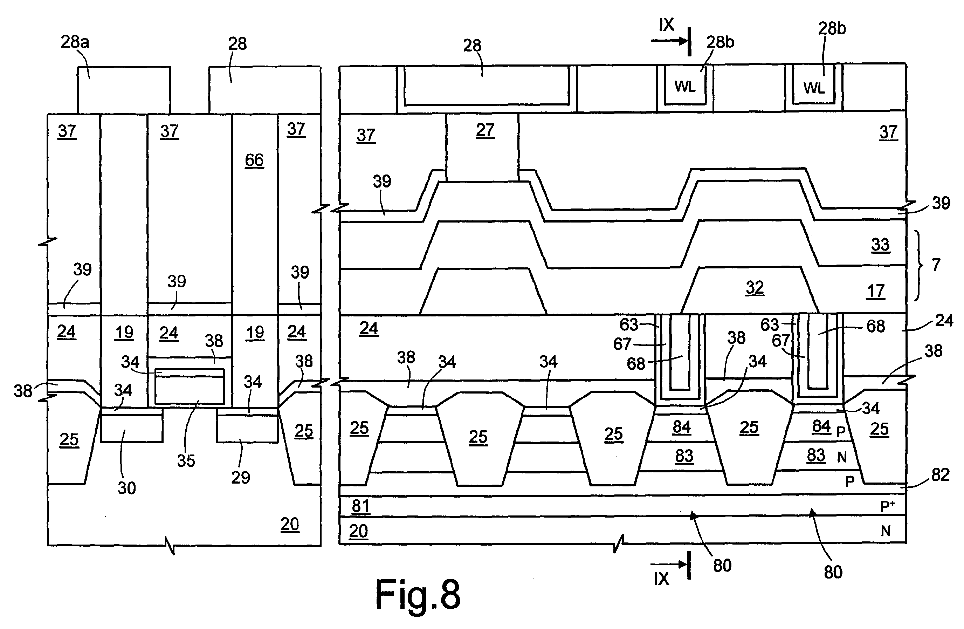

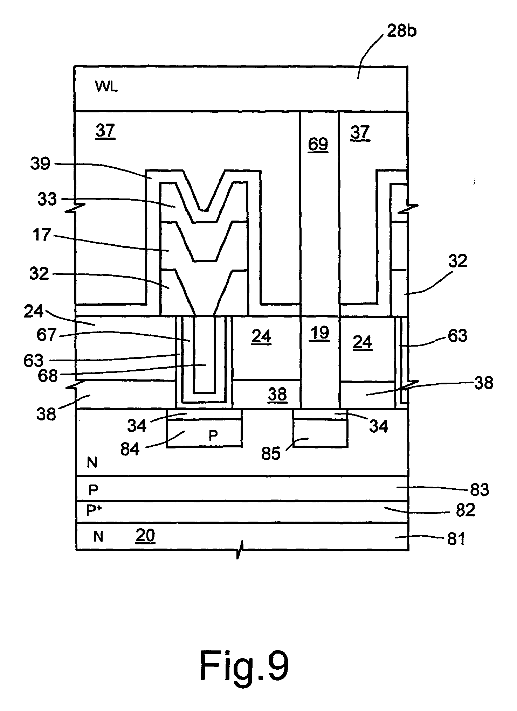

Figures 8 and 9 show cross-sections of a structure in which the selection element of the memory cell 61 is formed by a bipolar transistor 80 of a vertical PNP type. In detail, Figures 8 and 9 correspond to cross-sections in a direction parallel to the bitline 7 and, respectively, in a direction parallel to a wordline 6.

The bipolar transistor 80 comprises a buried sub-collector region 81 and a buried collector region 82, respectively of P+ and P type, a base region 83 of N type, an emitter region 84 of P+ type, formed within the base region 83, and a base contact region 85, of N+ type, also formed within the base region 83. Figures 8 and 9 moreover show a top metal connection line 28b forming the wordline 6 of Figure 4 and connected to the base contact region 85 via a first-level plug 19 and a second-level plug 69. In this case, the heater 63 extends vertically from the calcogenic material layer 17 as far as the emitter region 84 of the selection element 80 (or, more precisely, to the salicided region 34 overlying the emitter region 84), and the advantages deriving from the invention that have already been described for a selection element of a MOSFET type remain unaltered.

## Claims

1. A phase-change memory cell (61), comprising a phase-change memory element (64) and a selection element (65; 80) formed in a semiconductor material body (20) and connected to said phase-change memory element (64), wherein said phase-change memory element (64) comprises a calcogenic material layer (17) and a heater (63), **characterized in that** said selection element (65; 80) is in direct contact with said heater (63).

2. The phase-change memory cell according to claim 1, comprising a first dielectric material layer (24, 38) arranged on top of and contiguous to said semiconductor material body (20), and at least one second dielectric material layer (32) arranged on top of said first dielectric material layer (24, 38) and housing at least one portion of said calcogenic material layer (17), wherein said heater (63) extends within said first dielectric material layer (24, 38).

3. The phase-change memory cell according to claim 1 or 2, wherein said heater (63) is in direct contact with a silicided area (34) of said selection element (65; 80).

4. The phase-change memory cell according to any one of claims 1-3, wherein said heater (63) comprises at least one material in the group comprising TiSiN, TiAIN, and TiSiC.

5. The phase-change memory cell according to any one of claims 1-4, wherein said selection element is a MOSFET (65) or a BJT (80).

6. The phase-change memory cell according to any one of claims 1-5, wherein said calcogenic material layer (17) comprises GST (Ge₂Sb₂Te₅).

7. A memory array, comprising a plurality of phase-change memory cells (9, 61) according to any one of claims 1-6.

8. The memory array according to claim 7, comprising a column selector (15, 62) connected to at least one phase-change memory cell (61) of said plurality through a connection line (28), said connection line (28) being connected to said phase-change memory element (64) through a first conductive region (27) and to said column selector (62) through second conductive regions (66), wherein the difference in height between said first conductive region (27) and said second conductive regions (66) is less than 200 nm.

9. A process for manufacturing a phase-change memory cell (61), comprising the steps of:
- forming a selection element (65; 80) in a semiconductor material body (20); and
- forming a phase-change memory element (64);
wherein said step of forming a phase-change memory element (64) comprises forming a heater (63) and forming a calcogenic material layer (17), **characterized in that** said heater (63) is formed directly in contact with said selection element (65; 80).

10. The process according to claim 9, wherein said step of forming a selection element (65) comprises forming a silicided area (34), and wherein said heater (63) is formed directly in contact with said silicided area (34).

11. The process according to claim 9 or claim 10, wherein said step of forming a heater (63) comprises the steps of:
- depositing at least one dielectric material layer (24, 38) on top of said semiconductor material body (20) at said selection element (65; 80);
- forming an opening (71) in said dielectric material layer (24) ;
- depositing a heater layer (63) in said opening (71); and
- filling said opening (71) with at least one further dielectric material layer (67, 68).

12. A process for manufacturing a memory array comprising the steps of:
- forming a plurality of phase-change memory cells (61) according to any one of claims 9-11;
- forming a column selector (62) laterally with respect to said selection element (65; 80);
- forming at least one connection line (28);
- forming a first conductive region (27), which connects said connection line (28) to said phase-change memory element (64); and
- forming second conductive regions (66), which connect said connection line (28) to said column selector (62),
wherein the steps of forming a first conductive region (27) and second conductive regions (66) are carried out in a single step.

13. The process for manufacturing a memory array according to claim 12, **characterized in that** the steps of forming a first conductive region (27) and second conductive regions (66) comprise the step of anisotropically etching at least one dielectric layer (37,39).
